# EUROPEAN PATENT APPLICATION

(11) **EP 4 407 666 A1**
(43) Date of publication of application: **31.07.2024**
(21) Application number: 24150221.0
(22) Date of filing: 03.01.2024
(51) Int. Cl.: H01L 21/683, B29C 33/30, G03F 7/00, H01L 21/687

(54) **COMPONENT FOR MANUFACTURING MICRO- AND/OR NANOSTRUCTURED DEVICES AND METHOD OF MANUFACTURING THE SAME**

(30) Priority: 11.01.2023 NL 2033947
(71) Applicant: SUSS MicroTec Solutions GmbH & Co. KG, 75447 Sternenfels (DE)
(72) Inventor: SARCLETTI, Marco, 75447 Sternenfels (DE); VOGLER, Uwe, 75447 Sternenfels (DE)
(74) Representative: Prinz & Partner mbB

(57) **Abstract**

The invention relates to a component (32) for manufacturing micro- and/or nanostructured devices, having a base body (33) and a surface (34) which has micro- or nanostructures (48) which form a substantially flat support surface (52) and between which trenches (54) extend with a statistical distribution, to which a vacuum can be applied. The invention further relates to a method of manufacturing such a component.

## Description

The present invention relates to a component for manufacturing micro- and/or nanostructured devices. The invention further relates to a method of manufacturing the same.

In the manufacture of micro- and/or nanostructured devices, vacuum-based substrate holders are frequently employed for holding substrates such as wafers, films or thin glasses.

Conventional substrate holders have vacuum grooves having dimensions that are typically in the millimeter range. In the case of substrates having a low inherent rigidity, however, these can lead to undesirable compression and/or bending of the substrates during vacuum application.

Furthermore, in numerous applications it is necessary to be able to expose the substrates through the substrate holder, for example for structuring purposes or in order to cure materials located on the substrate.

In such cases, the substrate holder needs to be suitable to suck substrates reliably and with little deformation, and at the same time to expose them homogeneously.

Conventional as well as narrower vacuum grooves often lead to intensity variations of the light transmitted through the substrate holder. This causes unacceptable "coloring effects".

Sandblasted substrate holders, on the other hand, ensure a planar vacuum and homogeneous exposure, but have a high roughness that is difficult to control.

It is therefore the object of the invention to provide a vacuum system that allows a planar vacuum suction without compressions or bending of substrates and, at the same time, a homogeneous substrate exposure.

This object is achieved according to the invention by a component for manufacturing micro- and/or nanostructured devices, including a base body and a surface which has micro- or nanostructures which form a substantially flat support surface and between which trenches extend with a statistical distribution, to which a vacuum can be applied.

The basic idea of the invention is to form a flat support surface, in particular by a close-meshed arrangement of defined micro- or nanostructures. This means that, in comparison to sandblasting, a controlled and reproducible surface is produced.

Substrates can be sucked against the flat support surface, thereby avoiding compression or bending. The vacuum required for this is provided by the trenches.

Owing to their statistical distribution, any interfering scattering effects and/or incoherent superposition effects when light passes through the component are avoided, allowing a particularly homogeneous substrate exposure.

In particular, the statistical distribution may be a random arrangement of the trenches and/or a random width and/or depth of the trenches.

In other words, the trenches may have random variations in width and/or depth.

For example, one trench between two microstructures may have a width of 5 µm and/or a depth of 10 µm, whereas another trench between two other microstructures may be 10 µm in width and/or 20 µm in depth.

It is also conceivable that a maximum trench width depends on the thickness of the substrate to be held. For example, it may be provided that a maximum trench width is less than one tenth of the substrate thickness in order to ensure that no significant deflection and/or bending of the substrate into the trenches will occur.

Preferably, the maximum trench width is 20 µm at most. As has been found, trench widths below this value are well suited for applying a vacuum to most commonly used substrates without bending.

For example, the trench depth may be between 10 µm and 100 µm, preferably between 10 µm and 30 µm.

It is conceivable that the trenches are each equally wide and/or spaced apart equally far from each other and the statistical distribution consists only in the depth variation of the trenches.

It is also conceivable that a trench can not only have one particular depth, but several depth levels and/or a depth profile. This counteracts interference effects during exposure through the component.

It is, of course, also conceivable that the trenches exhibit statistical variations in both width and depth. Also, two or more trenches may intersect and/or transition into each other.

In particular, a completely random trench topography may exist between the micro- and/or nanostructures.

The micro- or nanostructures are preferably in the form of pins of at least approximately equal heights.

The pins may, for example, be formed to be quadrangular, in particular rectangular, or round.

The length and/or width of the pins is preferably < 20 µm, particularly preferably < 0.3 µm.

The length and/or width of the pins may also be dependent on the wavelength of the light used for the exposure. Thus, the pins should be narrower than the wavelength of the light used, for example the pins should be < 0.3 µm in length and/or width for an exposure with light of a wavelength in the range of 0.4 µm. As a result, there is particularly little interfering influence on the transmitting light.

The pins may, in particular, be arranged such that a specified maximum distance between them is not exceeded. This can be achieved in that the pins are arranged in a grid, for example in a square or hexagonal grid. The pins may be arranged regularly in the grid.

It is, however, also conceivable that the pins are arranged with a random offset with respect to the grid positions and/or that the grid includes cells, with a pin being arranged at a random position in each cell.

Preferably, the flat support surface is formed by the pin upper surfaces. The height of the pins should therefore vary as little as possible.

For example, it may be provided that the flatness of the support surface is < 2.5 µm, preferably < 0.5 µm. This means that the support surface formed by the pins does not deviate from an ideal plane by more than 2.5 µm or 0.5 µm, respectively, at any point.

The flatness may be predefined by the nature or quality of an initial body from which the component is made. In particular, the trenches may be introduced into this initial body by material removal. Here, no material is removed between the trenches, so that the flatness of the initial body is preserved.

According to one embodiment, the component is configured as a substrate holder for holding a substrate, in particular a stamp or stamp carrier, a mask or a wafer. A vacuum for holding the substrate can be applied to the trenches. This embodiment allows the aforesaid substrates to be held securely and without bending, for example in order to apply further materials to the respective substrate, to expose it and/or to structure it.

In a preferred variant, the component, in particular the base body and/or the microstructured surface with its micro- or nanostructures, is at least partially transparent, in particular to UV light. This has the advantage that a substrate that is held can be exposed directly through the component. In this way, exposure channels within the component and/or a lateral light injection, which is complex to implement, can be avoided.

The component may also be formed as a diffuser, with the micro- or nanostructures scattering the light, in particular UV light. This allows a particularly homogeneous and/or diffuse illumination of the substrate to be achieved, in particular also with collimated light.

In this connection, it is also conceivable that the illumination angles at which the light exits the base body may be adapted to the particular application.

Furthermore, the component may have an edge area that forms a part of the flat support surface and encloses the micro- or nanostructures. For example, the edge area may be formed to be very smooth and without trenches. When a substrate has been placed on top, the edge area may serve to close off the trenches toward the outside and in this way stabilize the vacuum below the substrate.

In a preferred embodiment, the edge area includes at least one vacuum channel. Provision may also be made for a plurality of vacuum channels, which are in particular evenly distributed in the edge area and open into the trenches toward the inside. This arrangement allows the vacuum to be applied to the trenches in a technically simple manner. There is no need for any central vacuum channels within the base body, which might interfere with the light injection.

In order to simplify an alignment of the component, in particular with a substrate suctioned, with respect to further components, it may be provided that a ratio of the widths of the trenches and of the micro- or nanostructures is greater than 7/3, preferably greater than 10/1, and/or an area ratio of the trenches and of the micro- or nanostructures is greater than 100/1.

Alternatively, it may also be provided that the ratio of the widths of the trenches and of the micro- or nanostructures is smaller than 3/7, preferably smaller than 1/10, and/or an area ratio of the trenches and of the micro- or nanostructures is smaller than 1/100.

In other words, either the trenches or the micro- or nanostructures may dominate the surface of the base body. The respectively non-dominant species only slightly influences the light passing through the base body, so that an alignment of the component with respect to the further devices can be observed through the base body with a comparatively sharp image.

The component according to the invention may be employed, for example, in the manufacture of stamps. In this case, a liquid or viscous stamp material is usually filled into a stamp replication device, applied onto a stamp carrier, brought to the desired shape by means of a shaped part, and subsequently cured. Curing can be effected, for example, by heating or by exposing to light through the component, in particular using UV light. In general, exposure can achieve faster curing than heating.

In this process, the stamp carrier or the fully cured stamp is held at the support surface of the component according to the invention by a vacuum, at least temporarily.

The component may further be employed in subsequent imprinting processes, in which the stamp is utilized to replicate the structures of the shaped part. Here, too, the stamp is fixed in place on the component by means of a vacuum and exposed through the component. It is important here that the stamp rests flat against the component so as not to deform.

The object of the invention is further achieved by a method of manufacturing a component according to the invention, comprising the step of:
producing, by means of a laser, preferably by laser ablation and/or laser-induced etching, a surface which has micro- or nanostructures which form a substantially flat support surface and between which trenches extend with a statistical distribution, to which a vacuum can be applied.

Laser structuring of the surface allows a targeted incorporation of the trenches into an initial body from which the component is manufactured, without a material removal being carried out between the trenches.

In this way, an already existing flatness of the initial body can be preserved when the support surface is formed.

In addition, the laser structuring can be used to easily and cost-effectively realize micro- or nanostructures of specific shapes, sizes and distributions that are specifically suited to the desired application.

Further advantages and features of the invention will be apparent from the description below and from the accompanying drawings, to which reference is made and in which:
- Figure 1 schematically shows a stamp replication device;
- Figure 2 shows a top view of the stamp replication device of Figure 1;
- Figure 3 shows the stamp replication device of Figures 1 and 2 in a closed state;
- Figure 4 shows a top view of a surface of a component according to the invention employed in the stamp replication device;
- Figure 5 shows a side view of the surface of the component from Figure 4;
- Figure 6 shows a top view of a surface of a second embodiment of a component according to the invention;
- Figure 7 shows a side view of the surface of the component of Figure 6;
- Figure 8 shows a top view of a surface of a third embodiment of a component according to the invention;
- Figure 9 shows a side view of the surface of the component from Figure 8; and
- Figure 10 shows a schematic illustration of a method of manufacturing a component according to the invention.

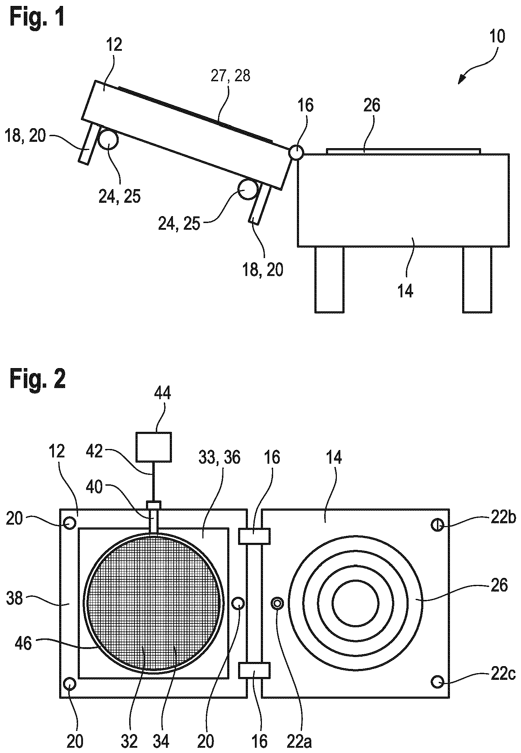

Figures 1, 2 and 3 schematically show a stamp replication device 10 for the manufacture of stamps for manufacturing micro- and/or nanostructured devices. The stamp replication device 10 comprises a cover 12 and a platform 14.

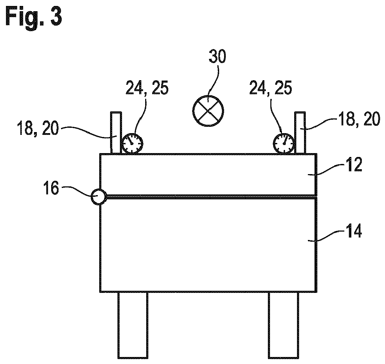

The cover 12 is pivotally mounted at the platform 14 by means of hinges 16 and can be placed on the platform 14, as illustrated in Figure 3.

In order to set a defined distance between the cover 12 and the platform 14 when the stamp replication device 10 is in the closed state, the stamp replication device 10 comprises a distance adjustment device 18, which includes, for example, three micrometer screws 20, which are preferably rounded at their ends directed toward the platform 14.

Correspondingly, three bearing areas 22a, 22b, 22c are provided on the platform 14 for supporting the cover 12, more particularly one bearing area 22a, 22c, 22b for each micrometer screw 20. One of the bearing areas 22a provides three degrees of freedom, another of the bearing areas 22b provides four degrees of freedom, and/or a further one of the bearing areas 22c provides five degrees of freedom.

The bearing areas are also illustrated in Figure 2. The bearing area 22a is formed by a conical depression. The bearing area 22b is formed by a V-shaped depression. The bearing area 22c is formed by a surface.

Furthermore, the stamp replication device 10 comprises a measuring device 24 for measuring the distance between the cover 12 and the platform 14. The measuring device 24 is configured separately from the distance adjustment device 18 here. As a result, changes in distance between the cover 12 and the platform that are not brought about by actuating the distance adjustment device 18 can also be detected. This allows the distance between the cover 12 and the platform 14 to be adjusted with particular precision.

The measuring device 24 comprises, for example, at least one dial indicator 25, preferably one dial indicator 25 per micrometer screw 20. Each dial indicator 25 is associated with a micrometer screw 20, but is implemented separately therefrom.

Moreover, the stamp replication device 10 comprises an irradiation source 30 for irradiating a liquid stamp material with light, in particular UV light. Such an irradiation source 30 is depicted in Figure 3. A stamp material provided in the stamp replication device 10 can be cured by being irradiated.

For this purpose, the irradiation source 30 may comprise a surface emitter and/or a collimator. Use of a surface emitter and/or a collimator allows a stamp material to be irradiated particularly evenly, which has a significant influence on the quality of the finished stamp.

The cover 12 is, for example, transmissive to light, in particular UV light, at least in some areas, to allow irradiation of the stamp material.

Figures 1 and 2 illustrate a shaped part 26 inserted in the stamp replication device 10. The shaped part 26 forms a negative image of the shape of the stamp to be manufactured. The shaped part 26 may be exchangeable, so that various shaped parts 26 can be used to manufacture different stamp geometries.

In addition, Figures 1 and 2 illustrate a stamp carrier 28 which is inserted in the stamp replication device 10 and which is non-detachably connected with the stamp material during the manufacture of a stamp.

During the manufacture of the stamp, both the shaped part 26 and the stamp carrier 28 are held on the platform 14 and on the cover 12, respectively, by means of a vacuum. This is necessary to prevent the stamp carrier 28 or the finished stamp from falling out inadvertently when the cover 12 is swiveled and to make sure that the shaped part 26 is held on the platform 14 and does not get stuck on the stamp when the cover 12 is swung open.

In order to hold the stamp carrier 28 in place, the stamp replication device 10 comprises a component 32 according to the invention, which in a first variant embodiment is in the form of a substrate holder 35 for holding a substrate 27, in particular the stamp carrier 28.

The component 32 comprises a base body 33 having a microstructured surface 34, which is configured as a vacuum surface.

The component 32, in particular the base body 33, is for example a plate 36 that can be inserted into the cover 12. Alternatively, the base body 33 may form the cover 12 or part of the cover 12.

In the exemplary embodiments illustrated, the base body 33 is enclosed by a frame 38, as can be seen in Figure 2, with the frame 38 and the base body 33 together forming the cover 12. The frame 38 is optional. It gives the base body 33 and/or the cover 12 particularly good stability.

The component 32, in particular the base body 33 and/or the microstructured surface 34 with its micro- or nanostructures 48, may be made of glass or quartz, as a result of which the component 32 is at least partially transmissive to light, for example to UV light, in particular to light of a wavelength of from 250 nm to 450 nm.

The shaped part 26 may be retained in a known manner, in particular likewise by means of a vacuum. For retaining the shaped part 26, however, no microstructured surface 34 is necessary, since the retaining of the shaped part 26 has no or no appreciable effect on the quality of a stamp.

Figure 2 shows the component 32 with the microstructured surface 34 in a top view. The microstructured surface 34 has, for example, the contour of the stamp carrier 28 so that the stamp carrier 28 covers it completely when the stamp carrier 28 is inserted in the stamp replication device 10 as intended. The stamp carrier 28 is not depicted in Figure 2 so as to permit a view of the microstructured surface 34.

In order to produce a vacuum at the microstructured surface 34, the component 32 includes a macroscopic vacuum channel 40, which is in fluid communication with the microstructured surface 34.

The macroscopic vacuum channel 40 is connected to a vacuum source 44 of the stamp replication device 10 via a conduit 42.

Furthermore, the component 32 includes a ring-shaped edge area 46 which encloses the microstructured surface 34.

The edge area 46 is formed to be very smooth and flat, and serves to close off the microstructured surface 34 to the outside, thus stabilizing the vacuum below the stamp carrier 28. The vacuum channel 40 extends at least in part within the edge area 46. In contrast, no vacuum channels are provided in the area of the microstructured surface 34 itself, since these could have an adverse effect on the homogeneity of exposure.

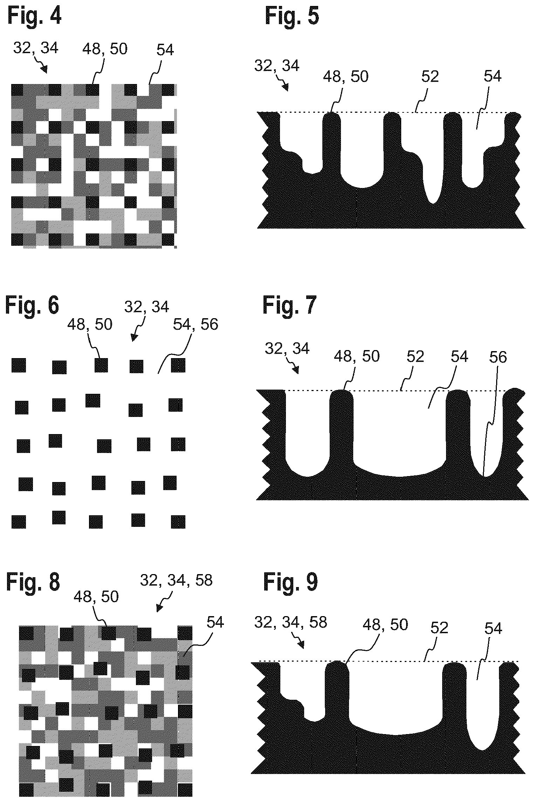

Figure 4 shows a detail of the surface 34 of the component 32 in a greatly enlarged top view. Figure 5 shows the surface 34 in a greatly enlarged side view.

The surface 34 includes a multitude of regularly arranged microstructures 48. In other words, the microstructures 48 are arranged in an ideal lattice structure.

In the exemplary embodiment, the microstructures 48 are formed as rectangular pins 50 of approximately equal heights. For example, the pins 50 may have a length and/or a width of about 0.3 µm. This should, of course, not be understood in a limiting sense. Other pin shapes as well as pin sizes, in particular in the nanometer range, are also conceivable.

The upper sides of the microstructures 48 constitute a substantially flat support surface 52 on which the stamp carrier 28 can rest in a flat state. In the exemplary embodiment, the edge area 46 also forms part of this support surface 52.

Extending between the microstructures 48 are trenches 54, to which a vacuum can be applied by means of the macroscopic vacuum channel 40.

In the exemplary embodiment shown, the trenches 54 are all of the same width. However, they have different depths.

In particular, individual trenches 54 may also have depth profiles with different depths. The variation in depth between the trenches 54 or also within a trench 54 is statistically distributed here. In other words, the depths of the trenches 54 are random and without a regular pattern. Therefore, the trenches 54 produce no or very limited interference effects on the light passing through the component 32.

Figures 6 and 7 show the surface 34 of a second embodiment of a component 32 according to the invention in a greatly enlarged top view and a greatly enlarged side view.

The second embodiment essentially corresponds to the first embodiment shown in Figures 4 and 5, so that only the differences will be discussed below. Identical and functionally identical elements are provided with the same reference numbers.

In contrast to the surface 34 shown in Figures 4 and 5, the surface 34 of the component 32 in the second embodiment does not include regularly arranged but statistically distributed microstructures 48.

Accordingly, the trenches 54 between the microstructures 48 are also statistically distributed and have random widths.

In the second embodiment, the trenches 54 are all of the same depth. The microstructured surface 34 can therefore be subdivided into two partial surfaces, namely the flat support surface 52 and the trench bottom 56.

As is shown in Figures 6 and 7, the trench bottom 56 is dominant with regard to the microstructured surface 34.

For example, the ratio of the mean trench width and the width of the microstructures 48 may be 10/1. For example, an area ratio of the trenches 54 and the microstructures 48 may be greater than 100/1.

Since the microstructures 48 of the surface 34 are not arranged regularly - for example, in an ideal lattice structure - but are statistically distributed, light passing through the component 32 is only slightly influenced by the microstructures 48. This results in an improved homogeneity of exposure, since periodic scattering effects are avoided.

Therefore, for example, the stamp carrier 28 can be observed through the component 32 with a comparatively sharp image and, if required, can be aligned with respect to the component 32 itself or with respect to the shaped part 26.

As an alternative, it may also be provided that a ratio of the widths of the trenches 54 and the microstructures 48 is smaller than 3/7, preferably smaller than 1/10, and/or an area ratio of the trenches 54 and the microstructures 48 is smaller than 1/100. In this case, the smooth support surface 52 dominates the microstructured surface 34. Light passing through the component 32 is only slightly influenced by the comparatively few or small trenches 54, so that observing through the component 32 is possible in this case as well.

Figures 8 and 9 show the surface 34 of a third embodiment of a component 32 according to the invention in a greatly enlarged top view and a greatly enlarged side view.

The third embodiment essentially corresponds to the first and second embodiments, so that only the differences will be discussed below. Identical and functionally identical elements are provided with the same reference numbers.

As in the second embodiment, the surface 34 of the component 32 in the third embodiment includes statistically distributed microstructures 48.

The trenches 54 between the microstructures 48 have different depths or statistical variations in depth, as in the first embodiment.

Accordingly, the third embodiment constitutes a hybrid form of the first and second embodiments.

The third embodiment of the component 32 is configured both to hold the stamp carrier 28 and to serve as a diffuser 58.

The randomly arranged microstructures 48 and trenches 54 very effectively scatter light passing through the component 32, in particular UV light.

This allows a particularly homogeneous illumination of the stamp carrier 28 and the stamp material applied thereon to be achieved.

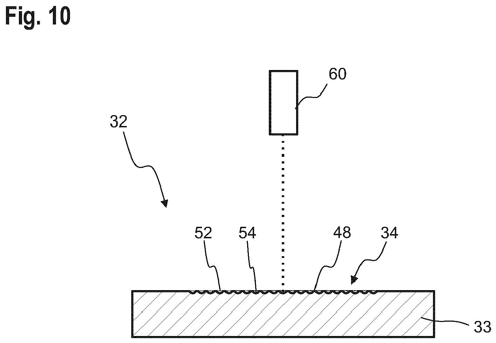

Figure 10 shows a schematic representation of a method of manufacturing a component 32 according to the invention.

In the exemplary embodiment, the starting point of the method is a plateshaped, flat base body 33, for example a glass plate or quartz plate.

In a method step, a microstructured surface 34 is produced on the base body 33 by means of a laser 60. The surface exhibits the micro- or nanostructures 48 described above.

In the exemplary embodiment, trenches 54 with a statistical distribution are incorporated into the base body 33 by laser ablation. In contrast, no material removal is performed between the trenches 54, that is, in the region of the microor nanostructures 48. As a result, the flatness of the base body 33 is preserved in the support surface 52.

Alternatively, the micro- or nanostructures 48 may also be ablated evenly.

The advantage of laser ablation is that the desired microstructures 48 can be produced quickly, precisely and with almost any desired layout. As an alternative, the trenches 54 may also be introduced by means of laser-induced etching, which offers similar advantages over conventional methods.

## Claims

1. A component for manufacturing micro- and/or nanostructured devices, comprising a base body (33) and a surface (34) which has micro- or nanostructures (48) which form a substantially flat support surface (52) and between which trenches (54) extend with a statistical distribution, to which a vacuum can be applied.

2. The component according to claim 1, wherein the trenches (54) have random variations in width and/or depth.

3. The component according to claim 1 or 2, wherein the micro- or nanostructures (48) are in the form of pins (50) of at least approximately equal heights.

4. The component according to any of the preceding claims, configured as a substrate holder (35) for holding a substrate (27), in particular a stamp or stamp carrier (28), a mask or a wafer, wherein a vacuum for holding the substrate (27) can be applied to the trenches (54).

5. The component according to any of the preceding claims, wherein the component (32) is at least partially transparent, in particular to UV light.

6. The component according to claim 5, formed as a diffuser (58), wherein the micro- or nanostructures (48) are configured to scatter light, in particular UV light.

7. The component according to any of the preceding claims, having an edge area (46) which forms part of the flat support surface (52) and encloses the micro- or nanostructures (48).

8. The component according to claim 7, wherein the edge area (46) includes at least one vacuum channel (40).

9. The component according to any of the preceding claims, wherein a ratio of the widths of the trenches (54) and of the micro- or nanostructures (48) is greater than 7/3, preferably greater than 10/1, and/or wherein an area ratio of the trenches (54) and of the micro- or nanostructures (48) is greater than 100/1.

10. The component according to any of claims 1 to 8, wherein a ratio of the widths of the trenches (54) and of the micro- or nanostructures (48) is smaller than 3/7, preferably smaller than 1/10, and/or wherein an area ratio of the trenches (54) and of the micro- or nanostructures (48) is smaller than 1/100.

11. A method of manufacturing a component (32) according to any of claims 1 to 10, comprising the step of:
- producing, by means of a laser (60), preferably by laser ablation and/or laser-induced etching, a surface (34) which has micro- or nanostructures (48) which form a substantially flat support surface (52) and between which trenches (54) extend with a statistical distribution, to which a vacuum can be applied.
